# EUROPEAN PATENT APPLICATION

(11) **EP 4 811 663 A1**
(43) Date of publication of application: **23.09.2026**
(21) Application number: 25165402.6
(22) Date of filing: 21.03.2025
(51) Int. Cl.: H03K 17/693, H03K 17/76, G06F 1/26, H02J 1/10

(54) **A HARDWARE SELECTOR FOR SUPPLYING VOLTAGE AND A METHOD FOR ITS MANUFACTURING**

(71) Applicant: KB Intellectual Property GmbH & Co. KG, 82049 Pullach (DE)
(72) Inventor: SCHOLL, Frank, 80809 München (DE); CARREON GUZMANN, Juan Omar, 80809 München (DE)

(57) **Abstract**

A hardware selector (100) for supplying voltage to a trailer interface (50) of a commercial vehicle is disclosed. The hardware selector includes a first input terminal (110) for providing a first voltage (U1) from a first power line; a second input terminal (120) for providing a second voltage (U2) from a second power line; and an output terminal (130) for supplying an output voltage to the trailer interface (50). The hardware selector (100) further includes a switch device (140) connected to the first input terminal (110), to the second input terminal (120) and to the output (130), the switch device (140) having a first state supplying the first voltage (U1) to the output terminal (130), and having a second state supplying the second voltage (U2) to the output terminal (130). The hardware selector (100) further includes an activation circuitry (150) configured to place the switch device (140) in the first state upon the first voltage (U1) being applied to the first input terminal (110), and to place the switch device (140) in the second state upon the second voltage (U2) being applied to the second input terminal (120).

## Description

The present invention relates to hardware selector for supplying voltage to a trailer interface and to a method of its manufacturing, and, in particular, to a supply selector (e.g. for 12V/24V) and for a trailer Controller Area Network, CAN, interface.

The CAN trailer interface is a system used in commercial vehicles to facilitate communication between a towing vehicle and a trailer. It enables the transfer of data and control signals ensuring that the trailer operates correctly in sync with the vehicle's systems.

Commercial vehicles are available with 12V or 24V supply voltage and the trailer interface which are compatible with both systems have to be switched accordingly. Selecting the correct voltage for the CAN trailer interface is crucial. If the supply voltages of the CAN trailer interface are hard-wired, there is no way to switch between the two different assembly variants. However, it is possible to measure the supply voltage (e.g. by a sensor input or a switching input) and based thereon to switch over accordingly via software.

Using a software to select between a low-power supply and a high-power supply may be based on a selector signal (e.g., a control signal from a controller). This conventional method has the disadvantage that at a power failure the selector signal may accidentally provide 24V instead of 12V. Furthermore, connected communication devices at the trailer may be distorted or even damaged if the wrong signal level is applied during powering up, e.g., after a reset or until the software is able to control the switch correctly.

Therefore, there is a demand for a robust system which is able to select the supply voltage automatically (hardware-based) to prevent any potential faults or damages, ensuring a reliable and safe operation of the trailer interface.

At least some of the problems of the conventional selectors as described before are overcome by a hardware selector of claim 1 or a method according to claim 14. The dependent claims refer to further advantageous realizations of the subject matter of the independent claims.

The present invention relates to a hardware selector for supplying voltage to a trailer interface of a commercial vehicle (e.g. a combination of towing vehicle and a trailer). The hardware selector comprises a first input terminal for providing a first voltage from a first power line, a second input terminal for providing a second voltage from a second power line, an output terminal for supplying an output voltage to the trailer interface. The hardware selector further comprises a switch device and an activation circuitry. The switch device is connected to the first input terminal, to the second input terminal and to the output terminal. The switch device provides a first state supplying the first voltage to the output terminal and a second state supplying the second voltage to the output terminal. The activation circuitry is configured to place the switch device in the first state upon (when) the first voltage being applied to the first input terminal. The activation circuitry is further configured to place the switch device in the second state upon (when) the second voltage being applied to the second input terminal.

It is understood that the term "connected" means electrically connected for a direct current (not galvanically separated), i.e. there is a current path available. Throughout this disclosure the term connected may be a direct connection, i.e. when no components are arranged in-between, or to an indirection connection, i.e. when another component (e.g. a resistor, a diode etc.) is arranged in-between.

It is further understood that the hardware selection selects the supply voltage for the output without the need of receiving any control signal but automatically based on the voltage levels being present at the first and/or at the second input terminals. Thus, the selection may be caused solely by the circuitry and the voltage levels being applied at the first and second input terminals. In other words, the selection is performed/achieved without relying on a control signal from a control unit, but automatically by the activation circuitry (due to wiring concept or used devices). The selection may be performed without delay, i.e. in direct response of an applied signal level.

Optionally, the activation circuitry is further configured to place the switch device in the first state, when the second voltage is applied to the second input terminal and the first voltage is applied to the first input terminal.

Therefore, the switch device is in the second state only when no first voltage is applied, and a second voltage is applied. In other words, whenever the first voltage is applied - regardless of whether the second voltage being applied or not - the switch device remains in its first state (i.e. the first voltage will be applied to the output terminal).

Optionally, the hardware selector may further comprise a filter (e.g., an inductor) along a current path from the first input terminal. According to embodiments, the filter may be configured to suppress transients (e.g., transient signals or peaks for a very short time) that shall not propagate to the trailer interface. This is of advantage in case the first power line is configured for a power line communication, PLC, which may be the case if the first voltage is, e.g., 12V and the second voltage is higher (e.g. 24V). In this case, the hardware selector detects the exemplary 12V which in turn may indicate that PLC may be utilized. However, it is understood that PLC can be implemented in the vehicle only optionally, but embodiments shall not be limited on this case. Likewise, a possibly available PLC circuitry will or may not be supplied by the selector. If no PLC is expected to be present, no filter needs to be formed. Alternatively, or in addition, the filter can be bypassed (e.g. by a jumper).

Optionally, the hardware selector may further comprise a first diode. The first diode may be arranged between the first input terminal and the output terminal to block a reversed current towards the first input terminal. Optionally, the hardware selector may further comprise a second diode, which may be arranged between the second input and the output terminal to block a reverse current towards the second input terminal.

Optionally, the hardware selector may comprise one or more switches. Each of switches may be formed as a field effect transistor, FET. Then, the first diode and/or the second diode may be formed as a body diode of the one or more FETs. It is understood that each diode (first diode, second diode, ...) can be any PN junction including the body diodes of FETs or any other transistor.

According to embodiments, the second voltage is higher than the first voltage. The first input terminal and the output terminal may be connected with a first current path. Similarly, the second input terminal and the output terminal may be connected with a second current path. Then, optionally, the switch device may be configured to switch (i.e. to open and close) at least one of the following:
- only the second current path,
- between the first current path and the second current path,
- independently the first current path and the second current path.

According to embodiments, the first voltage is e.g., a 12V supply voltage, and the second voltage is e.g., a 24V supply voltage. However, these values are only examples and in further embodiments these values may be different.

When neither the first voltage is applied to the first input terminal nor the second voltage is applied to the second input terminal (default state), there are different possibilities. According to embodiments, in this default state:
- the first current path can be closed (i.e. a current can flow),
- the second current path can be closed,
- neither the first nor the second current path is closed.

However, whenever a voltage is present, the hardware selector will assume one of the well-defined states as defined before.

Optionally, the switch device may include a first FET and a second FET. The first FET and the second FET may comprise each a source, a drain, and a gate, and may be each an enhancement-mode FET (e.g. a p-channel FET). This means that the utilized FETs may be self-depleting. The first FET and the second FET may be connected in serial connection with their drains, i.e. both FETs are connected anti-serial. connected to each other and their sources are connected on one side to second input terminal and on the other side to the output terminal. The second diode may then be a body diode of the second FET connected with its source terminal to the output terminal. Thus, the second current path may be switched using two FETs. On the other hand, along the first current path, a switch or a FET does not need to be present. As long as the second voltage is higher than the first voltage, the above-described switching can be satisfied even without such a switch.

According to further embodiments the FETs can be connected differently. For example, the sources and drains can be exchanged, or the FETs can be rotated about 180°. Likewise, the p-channel and n-channels FETs can both be utilized in embodiments, i.e. all or some FETs can be exchanged by FETs with an opposite channel. A person skilled in the art will be able to adapt the circuitry easily without departing from the inventive concept.

Optionally, the activation circuitry may include a first driver circuitry, e.g. to drive the first FET. The first driver circuitry may include a first voltage divider and a first driver FET. The first voltage divider can couple to or between the source of the first FET and (to) the first driver FET (e.g. to its drain). The first driver FET may be coupled between the first voltage divider and a common node which is coupled to a ground terminal (e.g. via a resistor and/or a diode). An output of the first voltage divider can be coupled to the gate of the first FET to control it. The first driver circuitry may be controllable via a gate terminal of the first driver FET to drive or control the first FET.

Optionally, the activation circuitry may include a second driver circuitry, e.g. to drive the second FET. The second driver circuitry may include a second voltage divider and a second driver FET. The second voltage divider can couple to or between the source terminal of the second FET and a second driver FET (e.g. to its drain). The second driver FET can couple between the second voltage divider and the common node. The output of the second voltage divider can couple to the gate of the second FET. The second driver circuitry may be controllable via the gate of the second driver FET to drive or control the second FET.

Optionally, the hardware selector comprises further a third voltage divider. The third voltage divider may be formed between the second input terminal and the ground terminal. An output of the third voltage divider may be connected to the gate of the first driver FET as well as to the gate of the second driver FET.

Optionally, the hardware selector further comprising a fourth voltage divider. The fourth voltage divider may be formed between the first input terminal and the ground terminal. Optionally, an output of the fourth voltage divider may be connected to the common node (provides the source voltage level of the first and second driver FET).

Optionally, the hardware selector further comprises a third diode. The third diode may be formed inside the fourth voltage divider between its output and its connection to the first input terminal. Optionally, the hardware selector comprises further a fourth diode. The fourth diode may be formed between the output for the fourth voltage divider and the common node. The third diode and the fourth diode may be arranged to decouple the first input terminal and the second input terminal (i.e. an electric current in both direction). The third diode is poled to allow current flowing to the output of the fourth voltage divider when the first voltage is applied to the first input terminal. Accordingly, the fourth diode is poled in an opposite direction thereto.

Optionally, the hardware selector comprises further a first Zener diode connecting the gate and the source of the first FET and/or a second Zener diode connecting the gate and the source of the second FET. According to embodiments, the first and second Zener diodes can be configured to limit gate-source voltage at the first FET and/or at the second FET.

Further embodiments relate to a printed circuit board, PCB. The printed circuit board is configured to provide circuit lines (conducting tracks) and slots for the components of the hardware selector as described in this disclosure. According to embodiments, the PCB can be empty (e.g., the PCB does not have any pre-installed electronic components), however slots, contact pads, or mounting points are available to equip the board with the components defined in the claims.

Optionally, the printed circuit board may comprise further a controller input terminal for external control signals and a slot for a resistor (resistor slot) to connect the controller input terminal with the gate of the first driver FET and the gate of the second driver FET to drive the switch device based on the external control signals at the controller input terminal. The external control signals can be provided by an external controller to implement a software selector.

Optionally, the PCB may be equipped with all components described before, up to the third and fourth voltage divider. Instead of the third and fourth voltage divider the resistor at the controller input terminal may be placed in the respective resistor slot. The resulting voltage selector can be controlled by input control signals at the controller input terminal to control the first and the second driver FETs which in turn control the first and second FETs to open or close the second current path from/to the second input terminal.

Further embodiments relate to a method for manufacturing a selector for voltage supply to a trailer interface. The method comprises:
- providing a printed circuit board as described in this disclosure;
- implementing a hardware selector by placing the components of the hardware selector as described in this disclosure on the printed circuit board, or
- implementing a software selector by placing a resistor in the resistor slot and by providing the controller input terminal for a connection to an external controller which provides the external control signals.

During operation, the controller may provide the external control signals to the controller input terminal to enable either the first voltage or the second voltage supplied to the output terminal. The controller input terminal is connected, via the resistor, to the gate of the first driver FET and to the gate of the second driver FET which are turned on/off to open/close the second current path.

Embodiments provide the advantage of supplying automatically the correct voltage selected from two different power lines and supply it to a trailer interface of a commercial vehicle. There is no risk that the wrong voltage level is supplied to the trailer interface. Therefore, embodiments can particularly be used for vehicles where reliable and safe operation of the trailer interface is needed.

Some examples of the hardware selector will be described in the following by way of examples only, and with respect to the accompanying figures, in which:
- Figs. 1A-1E: show different hardware selectors for supplying power according to various embodiments of the present invention;
- Fig. 2: shows further details of the hardware selector according to embodiments;
- Fig. 3: depicts schematically a flow diagram for a method for manufacturing a selector of voltage supply to a trailer interface according to embodiments.

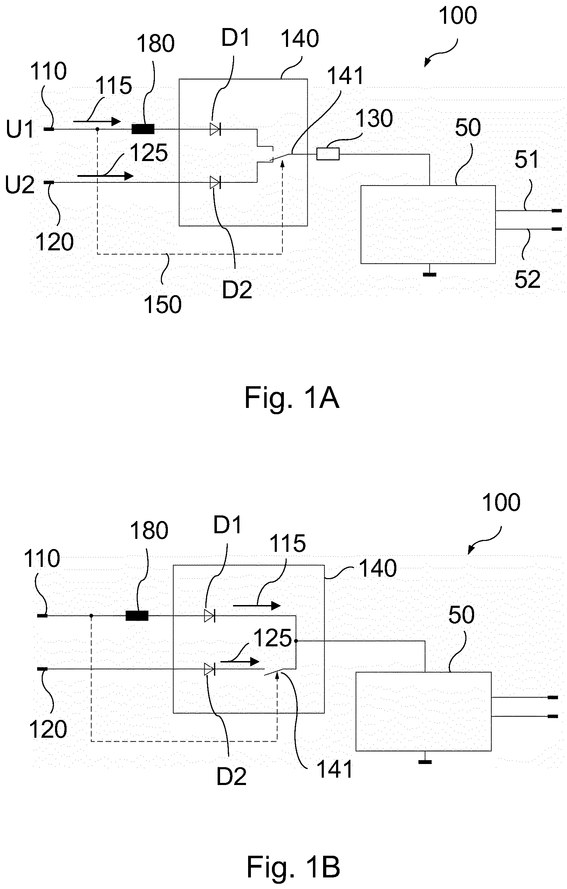

**Fig. 1A** shows a hardware selector 100 for supplying voltage to a trailer interface 50 of a commercial vehicle, which is configured to tow a trailer. The hardware selector 100 includes a first input terminal 110, a second input terminal 120, an output terminal 130, a switch device 140, and an activation circuitry 150. The first input terminal 110 provides a first voltage U1 from a first power line. The second input terminal 120 provides a second voltage U2 from a second power line. The output terminal 130 supplies an output voltage to the trailer interface 50.

The trailer interface 50 may be an interface for a Controller Area Network (CAN) to be used by the trailer. A CAN network may comprise at least two signal lines a CAN_H 51 and a CAN_L 52, wherein the CAN_H 51 carries higher voltage when compared to CAN_L 52.

The switch device 140 is connected to the first input terminal 110, to the second input terminal 120 and to the output 130. The switch device 140 allows a first state when it supplies the first voltage U1 to the output terminal 130. The switch device 140 allows a second state when it supplies the second voltage U2 to the output terminal 130.

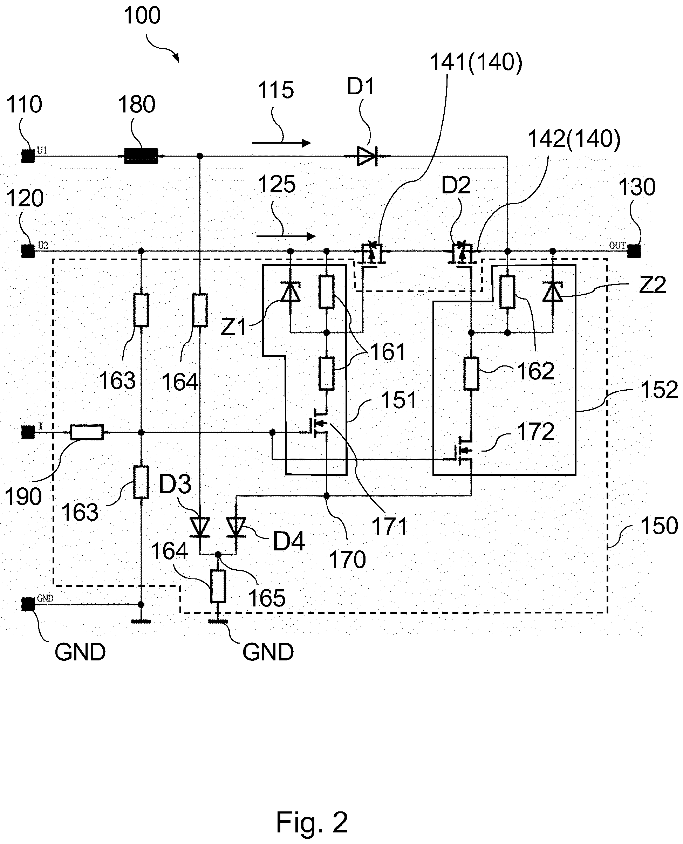

Here and in the following, the activation circuitry 150 may be shown only schematically by one or more dashed lines. A concrete realization will be described further below with **Fig 2****.** In all embodiments the activation circuitry 150 is configured to place the switch device 140 in the first state when the first voltage U1 is applied to the first input terminal 110 (not shown), and to place the switch device 140 in the second state when the second voltage U2 is applied to the second input terminal 120 (shown in **Fig. 1A****).** According to embodiments the activation circuitry 150 is further configured to place the switch device 140 in the first state, when the second voltage U2 is applied to the second input terminal 120 and the first voltage U1 is applied to the first input terminal 110. Thus, whenever a first voltage U1 is applied to the first input terminal 110, the first voltage U1 is applied to the output terminal 130.

According to embodiments, the switch device 140 comprises a first switch 141 to implement the defined switching operations. The switch device 140 is thus able to switch different current paths. For example, the first input terminal 110 and the output terminal 130 can be connected with a first current path 115. The second input terminal 120 and the output terminal 130 can be connected with a second current path 125. In the embodiment depicted in **Fig. 1A****,** the switch device 140 is configured to enable either the first current path 115 or the second current path 125. The first current path 115 and the second current path 125 will join each other at a merging point, which in **Fig. 1A** is the first switch 141.

According to embodiments, the hardware selector 100 may comprise a filter 180 along the first current path 115, which may be arranged between the first switch 141 and the first input terminal 110. The filter 180 may be adapted to suppress communication signals from a possible power line communication, PLC, or other signals that may interfere with the trailer interface 50. Advantageously, the first power line may be utilized for PLC.

According to embodiments, the switch device 140 further comprises a first diode D1 arranged along the first current path 115 between the first input terminal 110 and the output terminal 130 to block a reversed current towards the first input terminal 110. For example, the first diode D1 may be arranged upstream from the first switch 141, wherein the term "upstream" can be defined here and in general as the direction towards the inputs. The switch device 140 may further comprise a second diode D2 arranged between the second input 120 and the output terminal 130 to block a reverse current towards the second input terminal 120 (e.g. by arranging the second diode D2 upstream the first switch 141).

According to embodiments the default position of the first switch 141 can be any of the two positions. In other words, when neither the first voltage U1 nor the second voltage U2 is applied at the first and second input terminals 110, 120, the first switch 141, can remain at its last position or can disable the first current path 115 or can disable the second current path 125 or can disable both current paths 115, 125 or can stay in a random position. It is understood that a current path is disabled, when no electric current can flow (e.g. because a switch is open). On the other hand, a current path is enabled if and only if an electric current can flow (e.g. because the respective switch is closed).

In the depicted embodiment the switching device 140 is formed as a toggle. This has the advantage that no current can flow from one voltage supply to the other (e.g., from the first input terminal 110 to the second input terminal 120 or vice versa). Both input terminals 110, 120 are a decoupled from one another and are not subject to any revers current.

**Fig. 1B** to **Fig. 1E** illustrate various embodiments for the switch device 140.

**Fig. 1B** depicts an embodiment for the switch device 140 where - in comparison to the embodiment of the **Fig 1A** - only the first switch 141 has changed. The first switch 141 is now configured to enable and disable only the second current path 125, but not the first current path 115. It is not a toggle for both current paths 115, 125 as in **Fig. 1A****.** In this embodiment, the first current path 115 is always available (i.e. it is permanently enabled). The merging point of the first current path 115 and the second current path 125 is now formed between the first diode D1 and the first switch 141.

According to this embodiment the first switch 141 can be open in the default position, i.e. the second current path 125 is blocked (not enabled).

This arrangement may be of advantage in case the first voltage U1 is lower than the second voltage U2 (i.e. U2 > U1), wherein the first switch 141 will ensure the higher voltage cannot unintentionally be applied to the output terminal 130.

All other components in this embodiment of the hardware selector 100 can be formed as in **Fig. 1A****.** There is no need to repeat the description.

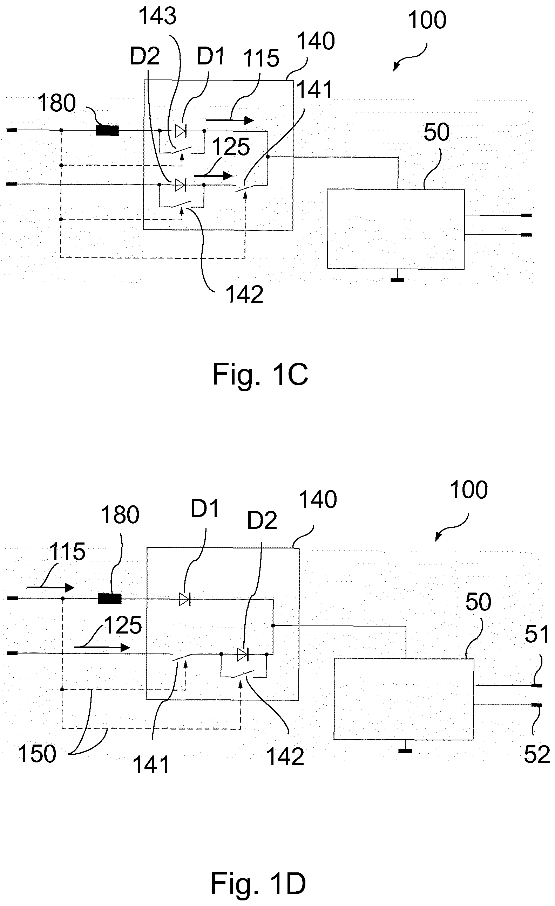

**Fig. 1C** depicts an embodiment for the switch device 140 where - in comparison to the embodiment of the **Fig 1B** - additional switches are formed. According to this embodiment the switch device 140 comprises three switches: the first switch 141, a second switch 142 and a third switch 143. The first switch 141 is formed as described in **Fig. 1B** to switch (only) the second current path 125. The second switch 142 provides a bypass for the second diode D2, i.e. the second diode D2 and the second switch 142 are arranged as a parallel connection along the second current path 125. The third switch 143 provides a bypass for the first diode D1, i.e. the first diode D1 and the third switch 143 are arranged as a parallel connection along the first current path 115.

The first switch 141 together with second switch 142 are now configured to enable and disable only the second current path 125. The third switch 143 is now configured to enable and disable (only) the first current path 115.

According to this embodiment the first switch 141 and/or the second switch 142 and/or the third switch 143 can be open in the default position, where now the first current path 115 and the second current path 125 are blocked (not enabled).

This arrangement provides the advantage that the second and the third switches 142, 143 lower the on-resistances along the first current paths 115 and along the second current paths 125, because the loss voltage over the first diode D1 is lowered by the third switch 143 and the loss voltage over the second diode D2 is lowered by the second switch 142.

All other components of the hardware selector 100 can be formed as in **Fig. 1B**. There is no need to repeat the description.

**Fig. 1D** depicts an embodiment for the switch device 140 where - in comparison to the embodiment of the **Fig 1C** - the third switch 143 is omitted and the first switch 141 is placed upstream from the second diode D2 (i.e. between the second diode D2 and the second input terminal 120).

According to this embodiment the first switch 141 and/or the second switch 142 can be opened in the default position. In other words, the first current path 115 and the second current path 125 are blocked (not enabled) in this position. This arrangement may again be of advantage in case the first voltage U1 is lower than the second voltage U2 (i.e. U2 > U1), where the first switch 141 and second switch 142 will ensure the higher voltage cannot unintentionally be applied to the output terminal 130.

This arrangement provides further the advantage that first and second switches 141, 142 lower again the on-resistances along the second current paths 125, because the loss voltage over the second diode D2 is lowered by the second switch 142.

All other components of the hardware selector 100 can be formed as in **Fig. 1B** or in **Fig. 1C****.** There is no need to repeat the description here.

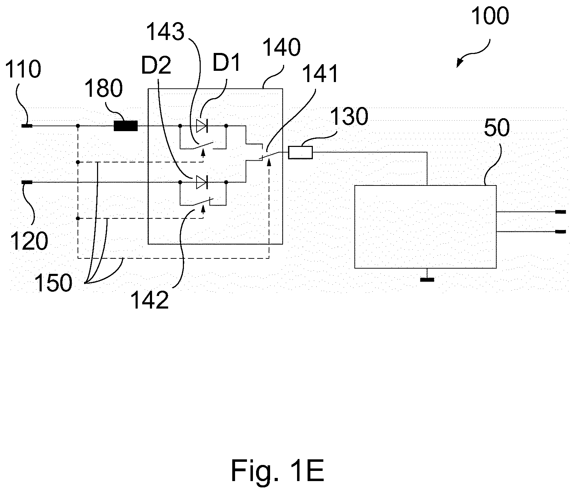

**Fig. 1E** depicts an embodiment for the switch device 140 where - in comparison to the embodiment of the **Fig 1A** - a second switch 142 and a third switch 143 are formed as bypasses for the first and the second diodes D1, D2. Concretely, the second switch 142 provides a bypass for the second diode D2, i.e. the second diode D2 and the second switch 142 are arranged as a parallel connection along the second current path 125. The third switch 143 provides a bypass for the first diode D1, i.e. the first diode D1 and the third switch 143 are again arranged as a parallel connection along the second current path 125. The first switch 141 is again formed as a toggle device.

According to this embodiment the second switch 142 and/or the third switch 143 can again be open in the default position, i.e. the first current path 115 and the second current path 125 are both blocked (not enabled).

As for the embodiment in **Fig. 1C****,** this arrangement provides the advantage that second and third switches 142, 143 lower the on-resistances along the first current paths 115 and along the second current paths 125, because the loss voltage over the first diode D1 is lowered by the third switch 143 and the loss voltage over the second diode D2 is lowered by the second switch 142.

All other components of the hardware selector 100 can be formed as in **Fig. 1A****.** There is no need to repeat the description.

In all embodiments, at least one of the first, second and third switches 141, 142, 143 can be formed as a FET. Accordingly, the first diode D1 and/or the second diode D2 in **Fig. 1C** to **Fig. 1E** can be formed as body diodes of the respective FET representing the second switch 142 and/or the third switch 143. This has the technical effect that the voltage drop is kept as low as possible complying with specifications of the CAN trailer interface 50 connected to the output terminal 130.

The switch device 140 can therefore be configured to switch at least one of the following:
- only the second current path 125 (see **Fig. 1B****,** **Fig. 1D****),**
- between the first current path 115 and the second current path 125 (see **Fig. 1A****),**
- independently the first current path 115 and the second current path 125 (see **Fig. 1C****,** **Fig. 1E****).**

**Fig. 2** depicts an embodiment of the hardware selector 100 showing further details about the activation circuitry 140. In this embodiment the second voltage U2 (e.g. 24V) may be chosen higher than the first voltage U1 (e.g. 12V). The first power line coupled to the first input terminal 110 may again be configured for PLC, wherein the filter 180 may again be formed to filter the respective communication signals. The filter 180 may comprise a coil or another inductive element to dampen fluctuating signal components or transients.

The first input terminal 110 and the output terminal 130 are again connected with a first current path 115. The second input terminal 120 and the output terminal 130 are again connected with a second current path 125. According to this embodiment, the switch device 140 is formed as described in **Fig. 1D** and switches only the second current path 125, wherein the switches are formed as FETs.

Concretely, the switch device 140 includes a first FET as first switch 141, and a second FET as second switch 142, wherein each FET 141, 142 has a source, a drain, and a gate. The first FET 141 and the second FET 142 are each an enhancement-mode FET and are connected in serial connection with their drains connected to each other. The source of the first FET 141 is connected to second input terminal 120. The source of the second FET 142 is connected to the output terminal 130.

The first diode D1 is connected between the source of the second FET 142 (or the output terminal 130) and the filter 180. The second diode D2 is a body diode of the second FET 142, i.e. connecting drain and source of the second FET 142.

In the following, details of the activation circuitry 150 are described, which may include all other components depicted in **Fig. 2** and which is connected between the input terminals 110, 120, the output terminal 130 and a ground terminal GND.

The activation circuitry 150 includes a first driver circuitry 151 and/or a second driver circuitry 152.

The first driver circuitry 151 is adapted to control the gate of the first FET 141 and includes a first voltage divider 161 and a first driver FET 171. The first voltage divider 161 couples between to the source of the first FET 141 and the first driver FET 171. The first driver FET 171 is coupled between the first voltage divider 161 and a common node 170 coupled to the ground terminal GND. An output of the first voltage divider 161 couples to the gate of the first FET 141. The first driver circuitry 151 is controlled via or through the gate of the first driver FET 171.

The second driver circuitry 152 is adapted to control the gate of the second FET 142 and includes a second voltage divider 162 and a second driver FET 172. The second voltage divider 162 couples between the source of the second FET 142 and the second driver FET 172. The second driver FET 172 is coupled between the second voltage divider 162 and the common node 170. An output of the second voltage divider 162 couples to the gate of the second FET 142. The second driver circuitry 152 is controlled via the gate of the second driver FET 172.

According to embodiments, the activation circuitry 150 further comprises a third voltage divider 163 and/or a fourth voltage divider 164. The third voltage divider 163 is formed between the second input terminal 120 and the ground terminal GND. An output of the third voltage divider 163 is connected to the gate of the first driver FET 171 and to the gate of the second driver FET 172. The fourth voltage divider 164 is formed between the first input terminal 110 and the ground terminal GND. An output 165 of the fourth voltage divider 164 is connected to the common node 170.

All voltage dividers 161, 162, 163, 164 may be formed as a serial connection of two resistors, where a node between the two serially connected resistors is an output of the respective voltage divider 161, 162, 163, 164. The resistances of the two resistors are selected to achieve a desired voltage level, e.g. to switch the FETs 141, 142, and the driver FETs 171, 172. The concrete values will depend on the concrete voltage levels at the first and second input terminal 110, 120 as well as on the concrete characteristics of the respective FETs, 141, 142, 171, 172.

According to embodiments the activation circuitry 150 further comprises one or more of the following:
- a third diode D3,
- a fourth diode D4,
- a first Zener diode Z1,
- a second Zener diode Z2.

The third diode D3 is formed inside the fourth voltage divider 164 between its output 165 and its connection to the first input terminal 110. The fourth diode D4 is formed between the output 165 for the fourth voltage divider 164 and the common node 170. The third diode D3 and the fourth diode D4 are arranged to decouple the first input terminal 110 and the second input terminal 120. Therefore, the cathodes of the third diode D3 and of the fourth diode D4 are (directly) connected with each other, whereas the anodes couple on one side to the common node 170 and on the other side to the first input terminal 110.

The first Zener diode Z1 is connected between the gate and the source of the first FET 141. The second Zener diode Z2 is connected between the gate and the source of the second FET 141. Both Zener diodes Z1, Z2 are intended to limit the gate-source voltage level of the FETs (i.e. of the first FET 141 and of the second FET 142). However, with appropriate resistor dimensioning, they may potentially be omitted.

The hardware selector 100 of **Fig. 2** provides all the functions defined before. It switches automatically the supply voltage U1 or U2 present at one of the input terminals 110, 120 to the output terminal 130. The first voltage U1 may be a 12V signal, which can be a PLC signal. Since this signal disturbs the supply voltage and hence the CAN trailer interface signals, the filter 180 is provided to suppress the corresponding distortions. To prevent a current flowing from one voltage supply to the other a decoupling is formed by the first and second diodes D1, D2.

In the following the two distinct cases are described in more detail:

### A. The second voltage U2 is applied

If, for example, a high voltage U2 (e.g. 24V) is applied to the second input terminal 120 and nothing is connected to first input terminal 110 (open), then the two FETs 141, 142 are switched on (provide a current path) and the high voltage U2 is supplied to the CAN trailer interface 50. For this, the first and second driver FETs 171, 172 are activated due to the high voltage U2 applied to the third voltage divider 163. This will, in turn, connect the first and second voltage divider 161, 162 to ground so that the gates of the first and second FETs 141, 142 receive the activation voltage to active both FETs 141, 142 and to open their (p-) channels for the second current path 125. In other words, the first FET 141 is activated via first driver FET 171 by a positive voltage difference between its gate and source. The second FET 142 is activated via its body diode D2 in combination with the first Zener diode Z1, second driver FET 172, and second voltage divider 162.

The first diode D1 and the third diode D3 are connected with their anodes to the first input terminal 110 and thus prevent a feedback current flowing to the lower voltage U1 at the first terminal 110.

### B. The first voltage U1 is applied

If now a lower voltage U1, such as 12V, is applied to the first signal input 110, then the CAN trailer interface 50 is supplied with this lower voltage U1 via the first diode D1. An additionally available higher voltage U2 at the second signal input 120 is switched off because the first driver FET 171 is blocked due to the fourth voltage divider 164 which raises the voltage level at its output 165. Thus, the sources of the first driver FET 171 (and of the second driver FET 172) is pulled up (they are not at ground anymore). Therefore, the voltage at its source raises relative to it gate, thereby blocking the first FET 141 and the second field-effect transistor 142.

The second FET 142 is thus prevented from being turned on (e.g. by parasitic paths), which could cause a feedback to the higher voltage U2. This is ensured by the source of the second driver FET 172 which is decoupled by the third diode D3 (connected with its anode to the source of the second driver FET 172).

Thus, the activations circuity 150 provides the advantage that both FETs, the first FET 141 and the second FET 142, cannot unintentionally be turned on - even though the hardware selector 100 has multiple parasitic paths. Likewise, any interactions between the first input 110 and the second input 120 is suppressed reliably. Even a short circuit at the output terminal 130 to a high voltage has no effect on the first input 110 or on the second input 120 (e.g. if the second voltage U2 is not applied and/or the controller is turned off). Thus, a back coupling to a controller connected to the first input terminal 110 and/or the second input terminal 120 is prevented.

The embodiment shown in **Fig. 2** has also a controller input terminal I, which is connected - via a resistor 190 - to the gate of the first driver FET 171 and to the gate of the second driver FET 172. This may provide a direct control of the switching of the first and second FET 141, 142 (through the first and second driver FET 171, 172) based on external control signals provided by an external controller (not shown).

Therefore, according to further embodiments, the selector may be operated based on external control signals that switch accordingly the first FET 141 and the second FET 142. However, if these external control signals intervene with the signal levels at the gates of the first and second driver FETs 171, 172, at least some of or all voltage divider 161, 162, 163, 164 can be deactivated or not formed when the selector shall be operated based on external control signals (i.e. software based).

According to embodiments, a printed circuit board on the which the hardware selector 100 is formed, can be preconfigured to allow also a software selector. Therefore, further embodiments relate also to a printed circuit board (not shown) configured to provide circuit lines for the hardware selector 100 as described before. The printed circuit board may further comprise the input terminal I for external control signals and a resistor slot for the resistor 190 to connect the input terminal I with the gate of the first driver FET 171 and with the gate of the second driver FET 172 to drive the switch device 140 based on the external control signals at the controller input terminal I. In this configuration, an external controller connected to the control input terminal I can select the supply voltage explicitly (e.g. software-based).

Further embodiments relate therefore also to the printed circuit board (PCB) which is preconfigured for forming thereon either the hardware selector 100 as described in this disclosure or the software selector described before. The pre-configuration of the PCB may include slots for the components of the selector (the FETs 141, 142, 171, 172, diodes D1 to D4, resistor 190, the coil 180) and/or conducting tracks to the electric connections as described before.

Further embodiments relate also to a method of manufacturing the hardware/software selector as described in this disclosure.

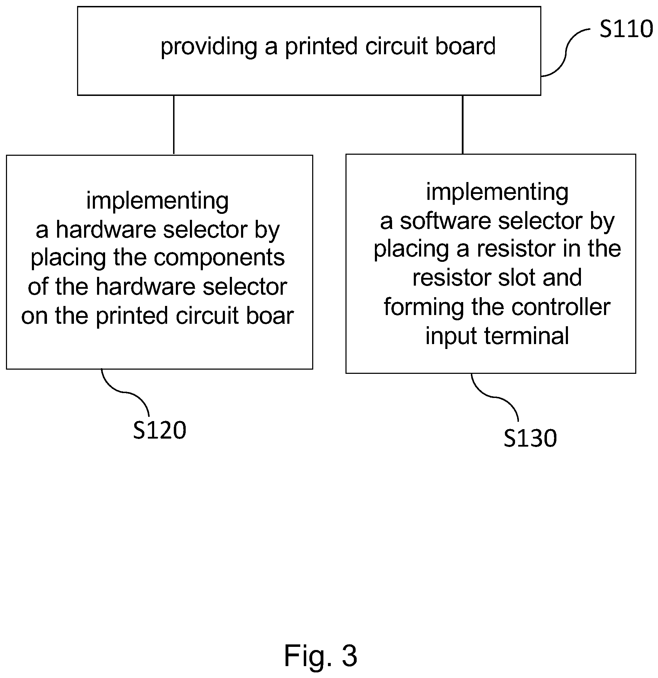

**Fig. 3** depicts an exemplary schematic flow diagram of a method for manufacturing a selector for voltage supply to a trailer interface 50. The method comprising the steps of:
- providing S110 a printed circuit board as described in this disclosure;
- implementing S120 a hardware selector by placing the components of the hardware selector 100 as described in this disclosure on the printed circuit board, or
- implementing S130 a software selector by placing a resistor in a resistor slot and forming the controller input terminal I for a connection to an external controller which provides in the external control signals.

The description and drawings merely illustrate the principles of the disclosure. It will thus be appreciated that those skilled in the art will be able to devise various arrangements that, although not explicitly described or shown herein, embody the principles of the disclosure and are included within its scope.

Furthermore, while each embodiment may stand on its own as a separate example, it is to be noted that in other embodiments the defined features can be combined differently, i.e. a particular feature descripted in one embodiment may also be realized in other embodiments. Such combinations are covered by the disclosure herein unless it is stated that a specific combination is not intended.

### LIST OF REFERENCE SIGNS

- 110: first input terminal
- 115: first current path
- 120: second input terminal
- 125: second current path
- 130: output terminal
- 140: switch device
- 141: first FET
- 142: second FET
- 150: activation circuitry
- 151: first driver circuitry
- 152: second driver circuitry
- 161: first voltage divider
- 162: second voltage divider
- 163: third voltage divider
- 164: fourth voltage divider
- 165: output of fourth voltage divider
- 170: common node (for driver)
- 171: first driver FET
- 172: second driver FET
- 180: filter
- 190: resistor
- D1: first rectifier (e.g. a diode)
- D2: second rectifier (e.g. a diode)
- D3: third rectifier (e.g. a diode)
- D4: fourth rectifier (e.g. a diode)
- Z1: first Zener diode
- Z2: second Zener diode
- GND: ground terminal
- I: controller input terminal (for external control signals)

## Claims

1. A hardware selector (100) for supplying voltage to a trailer interface (50) of a commercial vehicle,
**characterized by:**
- a first input terminal (110) for providing a first voltage (U1) from a first power line;
- a second input terminal (120) for providing a second voltage (U2) from a second power line;
- an output terminal (130) for supplying an output voltage to the trailer interface (50);
- a switch device (140) connected to the first input terminal (110), to the second input terminal (120) and to the output (130), the switch device (140) having a first state supplying the first voltage (U1) to the output terminal (130), and having a second state supplying the second voltage (U2) to the output terminal (130); and
- an activation circuitry (150) configured to place the switch device (140) in the first state upon the first voltage (U1) being applied to the first input terminal (110), and to place the switch device (140) in the second state upon the second voltage (U2) being applied to the second input terminal (120).

2. The hardware selector according to claim 1, wherein the activation circuitry (150) is further configured to place the switch device (140) in the first state, when the second voltage (U2) is applied to the second input terminal (120) and the first voltage (U1) is applied to the first input terminal (110).

3. The hardware selector according to claim 2, further comprising a filter (180) along a current path (115) from the first input terminal (110), the filter (180) being suitable for suppressing transient signals.

4. The hardware selector (100) according to any one of claims 1 to 3, the switch device (140) further comprising at least one of the following:
- a first diode (D1) arranged between the first input terminal (110) and the output terminal (130) to block a reversed current towards the first input terminal (110),
- a second diode (D2) arranged between the second input (120) and the output terminal (130) to block a reverse current towards the second input terminal (120),
- one or more switches (141, 142, 143) each being formed as a field effect transistor, FET, and the first diode (D1) and/or the second diode (D2) are formed as body diodes of the one or more FETs (141, 142, 143).

5. The hardware selector according to any one of claims 1 to 4, wherein the second voltage (U2) is higher than the first voltage (U1), and wherein the first input terminal (110) and the output terminal (130) are connected with a first current path (115), and the second input terminal (120) and the output terminal (130) are connected with a second current path (125), the switch device (140) being further configured to switch at least one of the following:
- only the second current path (125),
- between the first current path (115) and the second current path (125),
- independently the first current path (115) and the second current path (125).

6. The hardware selector according to claim 5, wherein the switch device (140) includes, along the second current path (125) a first field effect transistor, FET (141), and a second FET (142), the first FET (141) and the second FET (142), each comprising a source, a gate and a drain and are each an enhancement-mode FET and are connected in serial connection with their drains connected to each other and their sources are connected between second input terminal (120) and the output terminal (130).

7. The hardware selector according to claim 6, wherein the activation circuitry (150) includes at least one of the following:
a first driver circuitry (151) for the gate of the first FET (141) and including a first voltage divider (161) and a first driver FET (171), the first voltage divider (161) couples between to the source of the first FET (141) and the first driver FET (171), the first driver FET (171) is coupled between the first voltage divider (161) and a common node (170) coupled to a ground terminal (GND), an output of the first voltage divider (161) couples to the gate of the first FET (141), the first driver circuitry (151) being controllable via a gate of the first driver FET (171);
a second driver circuitry (152) for the gate of the second FET (142) including a second voltage divider (162) and a second driver FET (172), the second voltage divider (162) couples between the source of the second FET (142) and the second driver FET (172), the second driver FET (172) is coupled between the second voltage divider (162) and the common node (170), an output of the second voltage divider (162) couples to the gate of the second FET (142), the second driver circuitry (152) being controllable via a gate of the second driver FET (172).

8. The hardware selector according to claim 7, wherein the activation circuitry (150) further comprises at least one of the following:
a third voltage divider (163) formed between the second input terminal (120) and the ground terminal (GND), an output of the third voltage divider (163) being connected to the gate of the first driver FET (171) and to the gate of the second driver FET (172);
a fourth voltage divider (164) formed between the first input terminal (110) and the ground terminal (GND), an output (165) of the fourth voltage divider (164) being connected to the common node (170).

9. The hardware selector according to claim 8, further comprising at least one of the following:
a third diode (D3) formed inside the fourth voltage divider (164) between its output (165) and its connection to the first input terminal (110);
a fourth diode (D4) formed between the output (165) for the fourth voltage divider (164) and the common node (170),
wherein the third diode (D3) and the fourth diode (D4) are arranged to decouple the first input terminal (110) and the second input terminal (120).

10. The hardware selector according to any one of claims 6 to 9, further comprising at least one of:
a first Zener diode (Z1) connecting the gate and the source of the first FET (141);
a second Zener diode (Z2) connecting the gate and the source of the second FET (141).

11. A printed circuit board configured to provide circuit lines for the hardware selector (100) as defined in any one of claims 1 to 10 or for a software selector.

12. The printed circuit board of claim 11, as far as referred back to claim 7, further comprising:
a controller input terminal (I) for external control signals supplied to control the gate of the first driver FET (171) and to control the gate of the second driver FET (172) to drive the switch device (140) based on the external control signals to implement a software selector.

13. A commercial vehicle configured to be coupled to a trailer and with a hardware selector according to any one of claims 1 to 10 or with a software selector according to claim 12.

14. A method for manufacturing a selector for voltage supply to a trailer interface (50), the method comprising the steps of:
- providing (S110) a printed circuit board according to claim 11 or claim 12;
- implementing (S120) a hardware selector by placing the components of the hardware selector (100) as defined in one of claims 1 to 10 on the printed circuit board, or
- implementing (S130) a software selector by placing a resistor in the slot for the resistor (190) and by providing the controller input terminal (I) for a connection to a controller which provides in the external control signals.
